# FASCICULE DE BREVET EUROPEEN

(11) **EP 0 971 297 B1**
(45) Date de publication et mention de la délivrance du brevet: **26.09.2001**
(21) Numéro de dépôt: 99470016.9
(22) Date de dépôt: 30.06.1999
(51) Int. Cl.: G06F 17/50, G06F 1/10

(54) **Procédé de placement-routage d'un circuit d'horloge globale sur un circuit intégré, et dispositifs associés**
Verfahren zur Anordnung der Leitungsführung einer zentralen Taktgeberschaltung auf einem integrierten Schaltkreis sowie zugehörige Vorrichtungen
Method for global clock circuit routing and placement on an integrated circuit and associated devices

(30) Priorité: 10.07.1998 FR 9809008
(43) Date de publication de la demande: 12.01.2000
(73) Titulaire: STMicroelectronics S.A., 94250 Gentilly (FR)
(72) Inventeur: Fluxman, Steven, 57000 Metz (FR); Monk, Trevor, 57000 Metz (FR)
(74) Mandataire: Ballot, Paul Denis Jacques

(56) Documents cités:
- EP-A- 0 544 164
- US-A- 5 012 427
- US-A- 5 481 209
- US-A- 5 564 022
- US-A- 5 570 045
- GANGULY S ET AL: "Clock Distribution Methodology for PowerPCTM Microprocessors" JOURNAL OF VLSI SIGNAL PROCESSING, vol. 16, no. 2/03, 1 juin 1997 (1997-06-01), pages 181-189, XP000692609 NL

## Description

L'invention concerne un procédé de placement-routage d'un circuit d'horloge globale sur un circuit intégré, et dispositifs associés. Plus particulièrement, l'invention sert à réaliser la distribution globale d'un signal d'horloge tout ayant une bonne maîtrise de la phase de l'horloge sur toute la surface d'un circuit intégré de grande dimension.

Le placement-routage constitue une phase importante dans la conception des circuits intégrés. Le placement-routage réunit tout d'abord le placement des différents composants électroniques d'un circuit intégré puis la réalisation des connexions électriques à l'aide de conducteurs métalliques (ou en matériau fortement conducteur). Pour les circuits numériques, le placement routage peut être réalisé en tout ou partie à l'aide d'un logiciel communément appelé compilateur de silicium. Les compilateurs de silicium peuvent réaliser la totalité du placement-routage d'un circuit intégré en respectant les contraintes imposées par l'homme du métier pour le circuit et en prenant en compte des algorithmes de placement qui sont propres au logiciel. L'intervention de l'homme du métier dans le placement-routage sert essentiellement à faire des choix que la machine ne peut pas faire ou à réviser les contraintes imposées pour que la machine puisse réaliser la compilation. Pour diminuer les temps de calculs et de développement, on effectue un découpage en blocs fonctionnels qui sont testés de manière individuelle avant d'être assemblés sur le circuit intégré. Cela permet, entre autre, de pouvoir disposer de blocs fonctionnels complexes (par exemple un coeur de microprocesseur) communs à plusieurs circuits intégrés.

Par circuit intégré de grande dimension, il faut comprendre dans la présente demande les circuits intégrés dont les dimensions sont telles que le retard dû à la propagation d'un signal électrique, sur une ligne conductrice traversant de part en part le circuit intégré, n'est pas négligeable. Les circuits intégrés sont d'autant plus concernés par l'invention qu'ils travaillent à des fréquences élevées.

Lors de la conception d'un circuit au niveau fonctionnel, l'homme du métier considère généralement que les signaux d'horloge arrivent de manière synchrone sur tous les éléments d'un circuit intégré. Cependant, pour être sûr d'avoir un bon fonctionnement du circuit intégré, l'homme du métier doit tenir compte d'éventuels retards de phase sur l'horloge lorsqu'il effectue un bilan temporel du circuit. Or, le temps de propagation sur une ligne conductrice, dans un circuit intégré, dépend essentiellement de trois paramètres qui sont, pour une technologie donnée, la longueur du conducteur, la largeur du conducteur, et le nombre d'éléments qui sont connectés à cette ligne. Il peut arriver, sur des circuits de taille importante, que la tolérance prévu au départ soit erronée après le routage du circuit d'horloge globale, diminuant ainsi les performances du circuit intégré. Une augmentation des contraintes lors du routage du circuit d'horloge peut se traduire, dans certains cas, par une impossibilité de routage automatique, le circuit d'horloge globale étant le circuit le plus difficile à router. Dans certains cas, le non respect des performances temporelles peut rendre un circuit inutile ou inutilisable. Ces problèmes de distribution globale d'horloge sont connus de l'homme du métier qui dispose de solutions pour y remédier.

Une première méthode consiste à surévaluer les retards possibles. L'homme du métier est alors amené à concevoir un circuit plus rapide que les besoins réels. Cela revient à concevoir des circuits "surdimensionnés" et donc coûteux.

Une deuxième méthode consiste à maîtriser au maximum les retards induits par la propagation du signal d'horloge. Cette deuxième méthode se décline suivant différentes techniques de placement-routage de circuit d'horloge visant à réduire les différences de phases sur un signal d'horloge entre deux points quelconques d'un circuit intégré.

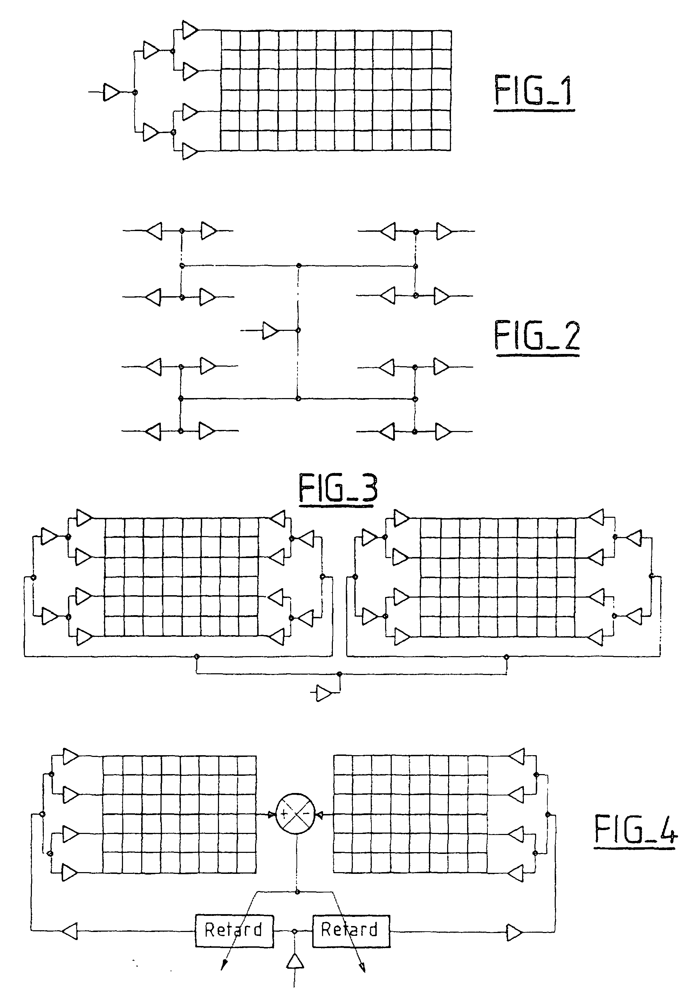

Une première technique est représentée sur la figure 1. Cette première technique consiste à réaliser une grille métallique pour distribuer le signal d'horloge sur la totalité du circuit. La grille métallique a pour premier effet de rendre négligeable les capacités dues aux éléments qui reçoivent le signal d'horloge, par rapport à la capacité parasite de ladite grille. Un deuxième effet produit par cette grille métallique est de réduire la résistance des conducteurs qui distribuent l'horloge. La combinaison de ces premier et deuxième effets est d'avoir une faible différence de phase sur la totalité du circuit. Cependant, la grille métallique présente deux inconvénients. Un premier inconvénient est lié à sa structure de grille qui utilise un niveau de métal complet ( ou une très grande partie de ce niveau de métal) sur le circuit intégré, rendant ledit niveau de métal inutilisable pour effectuer d'autres connexions. Un deuxième inconvénient est lié à la compensation des différences de phase qui tend à augmenter de manière considérable la capacité parasite de la grille métallique, la capacité parasite étant en plus dépendante de la surface du circuit intégré. Cette capacité parasite importante provoque une forte consommation du circuit intégré.

Une deuxième technique est représentée sur la figure 2. Cette deuxième technique consiste à placer sur toute la surface du circuit intégré des amplificateurs d'horloge identiques recevant tous le signal d'horloge par l'intermédiaire d'un réseau de distribution de type arborescent de telle sorte que tous les amplificateurs d'horloge reçoivent le signal d'horloge avec le même retard. Chaque amplificateur d'horloge distribue ensuite le signal sur une petite surface du circuit intégré dans laquelle les temps de propagation sur les lignes conductrices sont considérées comme étant négligeables. Chaque amplificateur d'horloge dispose d'un étage de sortie proportionnel au nombre d'éléments qui y sont connectés. un premier inconvénient de cette deuxième technique est la nécessité de placer tous les amplificateurs d'horloge sur le circuit intégré avant de placer les autres éléments du circuit intégré. Un deuxième inconvénient provient de la suppression d'un ou plusieurs amplificateurs d'horloge inutiles et/ou gênants (par exemple à cause d'un plan mémoire) car l'arborescence se trouve déséquilibrée et les amplificateurs d'horloge ne reçoivent plus le signal d'horloge en phase.

Une troisième technique, représentée sur la figure 3, combine les deux techniques précédentes. La surface du circuit intégré est divisée en plusieurs petites surfaces de dimensions identiques, chaque petite surface est recouverte d'une grille métallique. Les grilles métalliques sont ensuite connectées à une distribution d'horloge de type arborescente. Cela permet de réduire la consommation des grilles métalliques qui, étant de plus petite dimension, peuvent utiliser des conducteurs plus fins et réduire ainsi la capacité parasite de chaque grille. Par ailleurs, si une zone du circuit intégré n'a pas besoin d'horloge, les grilles métalliques peuvent être supprimées. Par rapport à la deuxième technique, les amplificateurs d'horloge sont placés entre les différents emplacements des grilles ce qui permet d'avoir un peu plus de souplesse pour placer les autres éléments du circuit intégré. Bien que diminués, les inconvénients des première et deuxième techniques sont toujours présents.

Une quatrième technique, représentée sur la figure 4, consiste à compenser dynamiquement les retards sur l'horloge à partir de points de mesure. Cette quatrième technique peut se combiner avec les deuxième et troisième techniques et permet de rééquilibrer partiellement une arborescence. Cependant, la compensation ne fait que déplacer le déséquilibre de phase et ne peut le compenser totalement.

Une cinquième méthode est décrite dans le document de brevet US-A-5 481 209. Le système de distribution d'horloge comprend un anneau, un tronc, des amplificateurs d'anneau/tronc et des buffers locaux, ces derniers étant affectés en fonction du partitionnement du circuit en sections et en régions suivant la charge. Au cas où le calcul de sa charge contributive s'avère très différente des autres, un buffer local peut voir sa charge capacitive ajustée ("metal tuning") pour diminuer son déphasage.

Un premier but de l'invention est de proposer une technique de placement-routage de circuit d'horloge sur la totalité d'un circuit intégré en réduisant les contraintes pour le placement d'autres éléments du circuit intégré tout en ayant une bonne maîtrise de la phase du signal d'horloge sur la totalité du circuit intégré. Un deuxième but de l'invention est d'avoir une faible consommation du circuit d'horloge.

L'invention a pour objet un procédé de placement-routage d'un circuit d'horloge sur un circuit intégré dont la surface s'étend selon des première et deuxième directions distinctes l'une de l'autre, le procédé comportant les étapes de placement de premières lignes conductrices parallèles à la première direction régulièrement espacées selon la deuxième direction, les premières lignes conductrices étant connectées sur au moins une extrémité à des sorties de premiers amplificateurs, un dispositif en structure d'arbre équilibrée fournissant à chacun des premiers amplificateurs un signal d'horloge provenant d'une unique source; de placement de blocs fonctionnels formant le circuit intégré et placement de secondes lignes parallèles à la deuxième direction, chaque seconde ligne étant associée à un bloc; de placement dans chaque bloc d'amplificateurs secondaires en fonction des besoins de chaque bloc, chaque amplificateur secondaire disposant d'un dispositif de retard ajustable en entrée puis routage de chaque amplificateur secondaire à la seconde ligne la plus proche; d'extraction d'un schéma électrique équivalent correspondant au parcours du signal d'horloge entre l'entrée du dispositif en structure d'arbre et l'entrée de chaque amplificateur secondaire; de simulation analogique du schéma électrique équivalent et mesure des retards de phase à l'entrée de chaque amplificateur secondaire; d'ajustement du retard d'entrée de chaque amplificateur secondaire pour correspondre au retard de phase le plus important.

Un troisième but de l'invention est de proposer un amplificateur d'horloge particulièrement bien adapté pour la mise en oeuvre de la technique de placement d'horloge de l'invention.

Ainsi, l'invention a également pour objet un amplificateur de signal d'horloge comportant un étage d'entrée et un étage de sortie, dans lequel l'étage d'entrée comporte un inverseur d'attaque qui reçoit sur son entrée le signal d'horloge, et au moins un condensateur d'ajustement connecté à la sortie de l'inverseur d'attaque.

L'invention se rapporte également à un circuit intégré ayant un circuit d'horloge qui comporte au moins un amplificateur de signal d'horloge dans lequel l'étage d'entrée comporte un inverseur d'attaque qui reçoit sur son entrée le signal d'horloge, et au moins un condensateur d'ajustement connecté à la sortie de l'inverseur d'attaque. Par ailleurs, le circuit d'horloge comporte une structure arborescente au moins partiellement équilibrée qui fournit un signal d'horloge à une série de premiers amplificateurs, et une structure de connexions non équilibrée qui relie les sorties des premiers amplificateurs à l'au moins un amplificateur de signal d'horloge.

L'invention sera mieux comprise et d'autres particularités et avantages apparaîtront à la lecture de la description qui va suivre, la description faisant référence aux dessins annexés parmi lesquels:
les figures 1 à 4 représentent schématiquement des circuits d'horloge réalisés selon l'état de la technique,
les figures 5 à 9 représentent schématiquement le placement-routage d'un circuit d'horloge global sur un circuit intégré selon l'invention,
les figures 10 à 12 représentent schématiquement le placement-routage du circuit d'horloge à l'intérieur d'un bloc fonctionnel du circuit intégré selon l'invention,
la figure 13 représente un amplificateur d'horloge d'un type classique,
la figure 14 représente un amplificateur d'horloge selon l'invention.

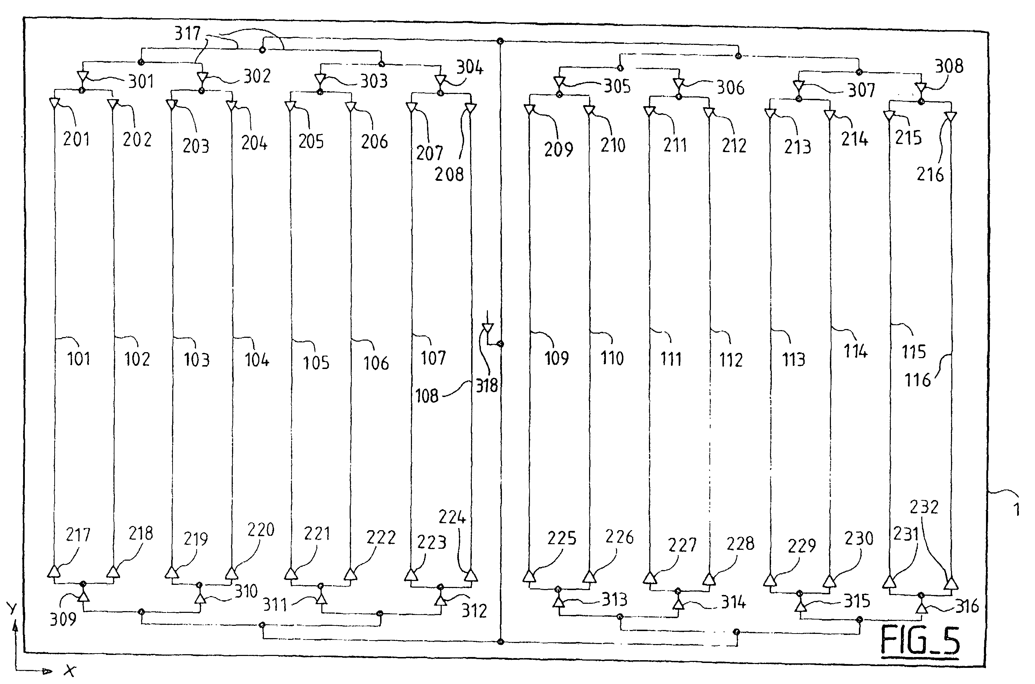

Les figures 5 à 9 représentent un circuit intégré 1 à différentes étapes de conception d'un circuit de distribution d'horloge globale. Ces figures 5 à 9 ne représentent pas les autres éléments figurants sur le circuit intégré pour ne pas surcharger les dessins. De même, ces figures ne sont pas à l'échelle car il aurait été impossible d'avoir un dessin lisible.

Le procédé de placement-routage qui va être décrit par la suite peut être réalisé avec le contrôle direct d'un homme du métier ou de manière entièrement automatique à l'aide d'un ordinateur programmé selon le procédé décrit.

On considère que la surface du circuit intégré est orientée selon deux directions X et Y qui sont distinctes l'une de l'autre. Ces directions sont par exemple perpendiculaires entre elles, mais ce n'est pas une obligation. La figure 5 représente le circuit intégré 1 après placement du réseau de distribution général. Pour obtenir ce réseau, on a effectué les étapes suivantes dans un ordre quelconque après évaluation de la surface totale du circuit intégré:
E1: On place des premières lignes 101 à 116 conductrices parallèles à la première direction Y et régulièrement espacées selon la deuxième direction X. Les premières lignes 101 à 116 s'étendent sur toute la largeur active du circuit intégré 1.
E2: On place des premiers amplificateurs 201 à 232 à chaque extrémité de chaque première ligne 101 à 116. Ces premiers amplificateurs 201 à 232 servent à fournir le signal d'horloge aux premières lignes 101 à 116. Ces premiers amplificateurs 201 à 232 sont d'un type connu, par exemple deux inverseurs en série.
E3: On place un dispositif en structure d'arbre pour fournir à chacun des premiers amplificateurs le signal d'horloge provenant d'une unique source. La structure d'arbre comporte, dans l'exemple décrit, des deuxièmes amplificateurs 301 à 316 dont les entrées sont toutes reliées ensemble par un conducteur à structure arborescente 317, le conducteur étant par ailleurs relié à la sortie d'un amplificateur central 318. L'entrée de l'amplificateur central est connectée soit à un générateur d'horloge interne, soit à une patte du circuit intégré 1, éventuellement par l'intermédiaire d'une boucle à verrouillage de phase.

La structure arborescente 317 est organisée de celle manière que le chemin parcouru, par un signal, entre la sortie de l'amplificateur central 318 et l'entrée de n'importe lequel des deuxièmes amplificateurs 301 à 316 est identique. Chaque deuxième amplificateur 301 à 316 a sa sortie connectée à deux des premiers amplificateurs 201 à 232. Ainsi, les premières lignes 101 à 116 reçoivent le signal d'horloge de manière synchrone à partir d'un arbre équilibré. Il est également possible que la structure arborescente 317 comporte des amplificateurs supplémentaire (d'un type classique) à chaque embranchement afin de diminuer la taille de l'amplificateur central 318. Dans ce cas, les amplificateurs supplémentaires doivent être placés de manière équilibrée.

Les premières lignes 101 à 116 ont un rôle (un peu similaire à une grille métallique de l'état de la technique) de répartition du signal d'horloge sur tout le circuit intégré 1. Cependant, ces premières lignes 101 à 116 sont beaucoup plus espacées et peuvent être plus fines que pour une grille métallique de l'état de la technique. A titre d'exemple, en technologie CMOS 0,35 µm, pour un circuit de 16 mm X 12 mm, les lignes sont espacées d'environ 1 mm et ont une largeur d'environ 2 µm. Pour réaliser plus facilement un arbre équilibré, on essaie d'avoir un nombre de premières lignes égal à une puissance de deux et, par exemple, espacées de 0,8 à 1,5 mm.

L'homme du métier peut remarquer que l'utilisation de premières lignes 101 à 116 a pour effet de provoquer un retard de phase en milieu de chaque ligne plus important qu'en bout.

Préférentiellement, ces premières lignes sont placées sur le même niveau de métal que les lignes conductrices assurant l'alimentation du circuit intégré 1 (VCC et masse). En effet, le fait de placer les premières lignes 101 à 102 entre les conducteurs d'alimentation assure avantageusement un blindage électromagnétique des premières lignes.

Il peut être suffisant, pour des circuits de plus faible dimension, d'utiliser un seul premier amplificateur par première ligne. La structure arborescente peut alors être divisée par deux. Le retard de propagation du signal d'horloge se faisant alors maximal entre les deux extrémités de chaque première ligne.

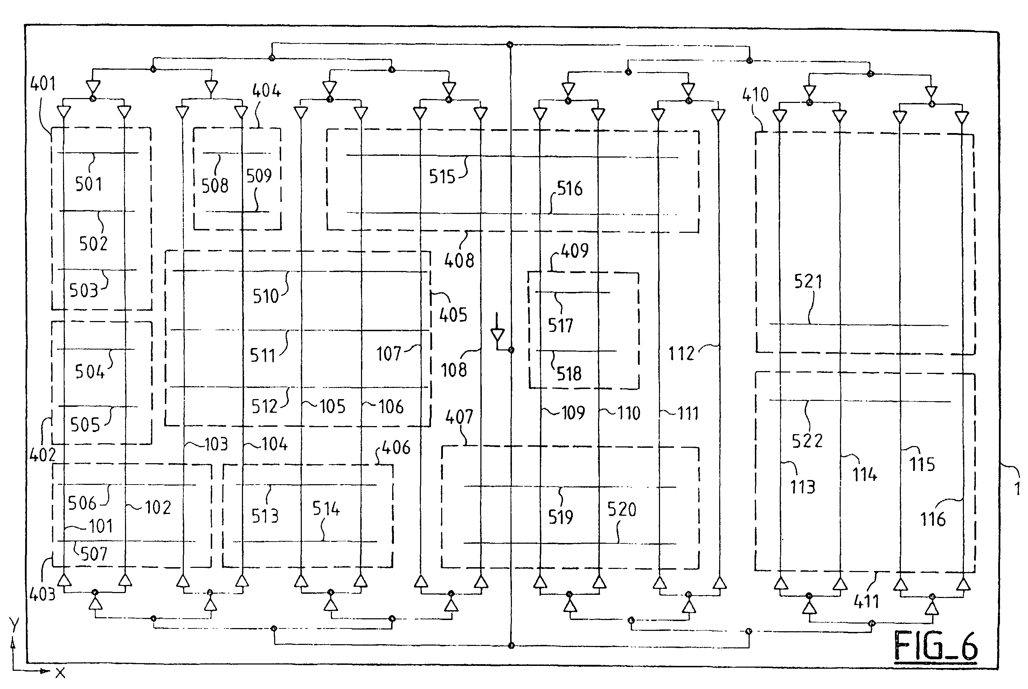

La figure 6 représente le circuit intégré 1 après placement des blocs fonctionnels. Pour obtenir cet état d'avancement, on a effectué les étapes suivantes dans un ordre quelconque:
E4: On évalue la taille des différents blocs 401 à 411 fonctionnels formant le circuit intégré, puis, on place les blocs 401 à 411 en tenant compte des bus de communication qui doivent relier les différents blocs 401 à 411.
E5: On place des secondes lignes 501 à 522 parallèles à la deuxième direction X, chaque seconde ligne 501 à 522 étant associée à un bloc 401 à 411.

L'évaluation de la taille de chaque bloc 401 à 411 peut se faire selon une méthode connue, il en va de même pour le placement des blocs sur le circuit intégré.

Le placement des secondes lignes 501 à à 522 peut se faire selon différentes méthodes suivant différents choix arbitraires et suivant la constitution fonctionnelle des différents blocs 401 à 411.

Une première méthode, par exemple pour le bloc 408, consiste à placer les deuxièmes lignes 515 et 516 de manière centrée par rapport à l'axe central du bloc qui est parallèle à la deuxième direction X et régulièrement espacées selon la première direction Y. L'espacement entre les secondes lignes 515 et 516 doit respecter des conditions sensiblement équivalentes aux conditions d'espacement des premières lignes 101 à 116, mais uniquement à l'intérieur du bloc 408 auquel elles sont associées. Les secondes lignes 515 et 516 s'étendent sur toute la longueur du bloc 408 concerné, mais s'arrêtent à une distance inférieure à la demi distance de séparation entre deux premières lignes. Il est également possible que les secondes lignes 510 à 512 s'étendent de part en part du bloc 405.

Si, par contre, on sait qu'un bloc 410 est par exemple une mémoire, alors on peut se contenter de positionner une unique seconde ligne 521 dans ce bloc 410 dans une région du bloc correspondant au circuit de contrôle de ladite mémoire.

Les critères de placement et d'espacement des secondes lignes 501 à 522 peuvent évidemment varier entre des blocs distincts. Toute combinaison est envisageable.

Préférentiellement, le placement des secondes lignes 501 à 522 se fait sur un niveau de métal différent du niveau de métal utilisé pour les premières lignes 101 à 116.

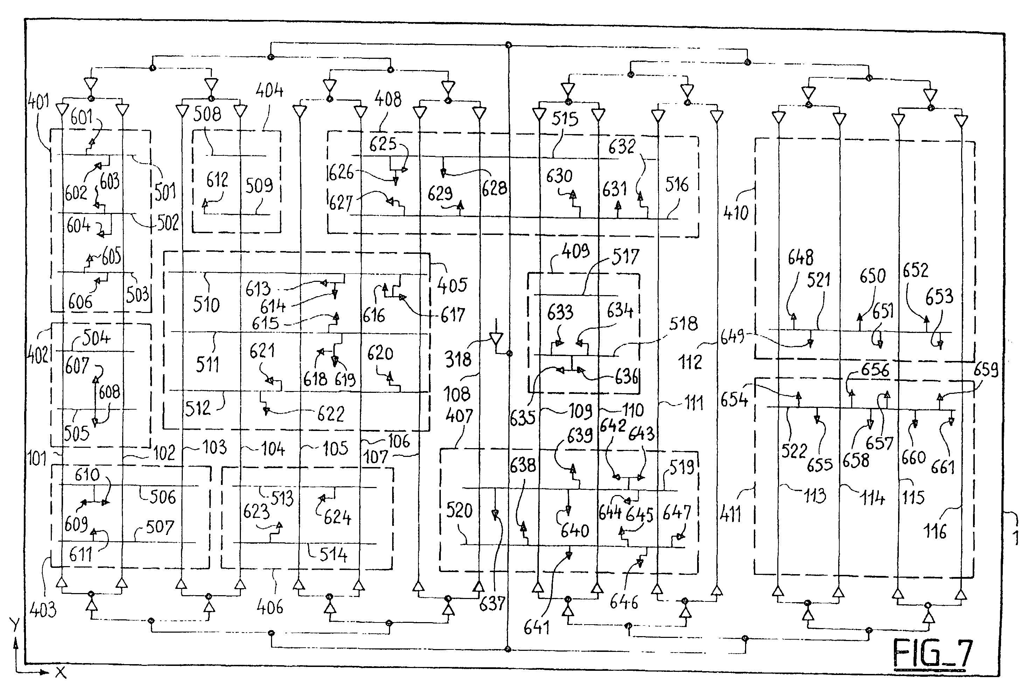

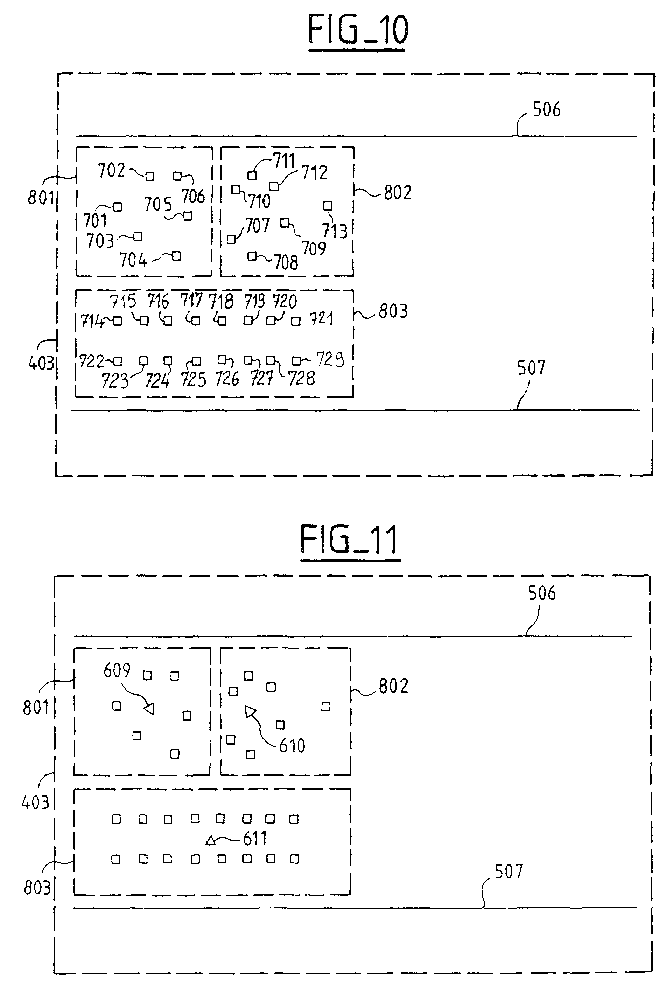

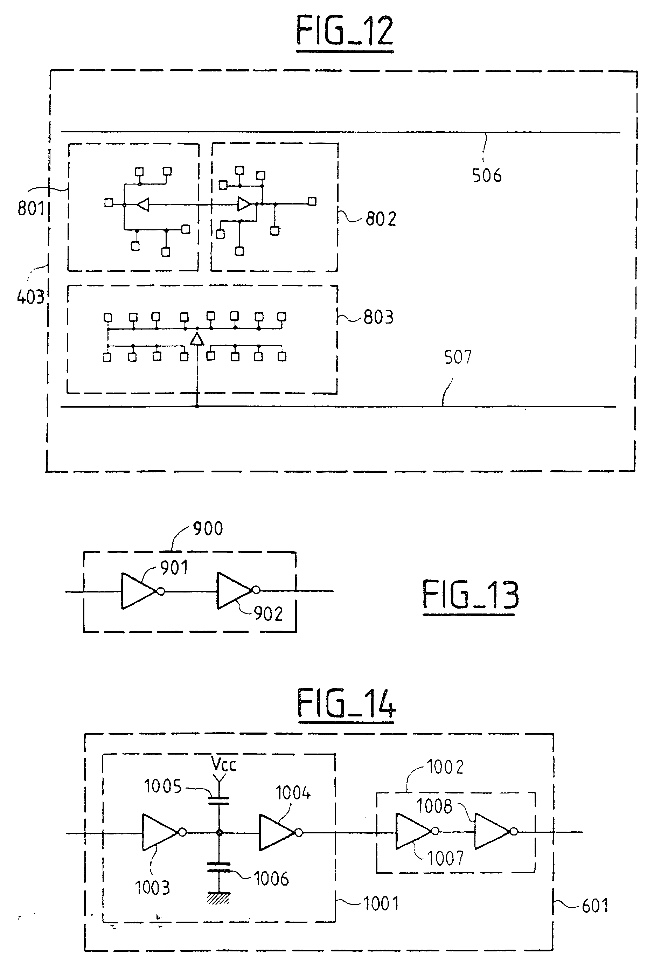

La figure 7 représente le circuit intégré 1 après placement-routage interne des blocs fonctionnels. Pour obtenir cet état d'avancement, on a effectué les étapes suivantes dans un ordre quelconque:
E6: On place dans chaque bloc 401 à 411 des amplificateurs secondaires 601 à 661 en fonction des besoins de chacun des blocs 401 à 411. Une méthode préférée de placement des blocs 401 à 411 sera détaillée par la suite à l'aide des figures 10 à 12. Chaque amplificateur secondaire 601 à 661 dispose d'un dispositif de retard ajustable en entrée qui sera détaillé par la suite à l'aide de la figure 14.
E7: On effectue le routage de chaque amplificateur secondaire 601 à 661 à la seconde ligne 501 à 522 la plus proche. Le tracé des connexions à l'intérieur de chaque bloc 401 à 411 est réalisé après le placement des différents éléments de chaque bloc 401 à 411. Bien évidemment, il est possible de modifier légèrement le placement des blocs si le routage s'avère impossible, comme déjà connu dans l'état de la technique.

Dans un exemple, la figure 7 correspond à un circuit fini. Cependant, pour que le circuit soit réellement fini, il convient de réaliser l'ajustement du circuit d'horloge comme indiqué dans les étapes suivantes:
E8: On effectue une extraction d'un schéma électrique équivalent correspondant au parcours du signal d'horloge entre l'entrée du dispositif en structure d'arbre et l'entrée de chaque amplificateur secondaire. L'extraction d'un tel circuit se fait de manière automatique en modélisant tout les transistors et tous les conducteurs dudit circuit à partir du modèle de sortie de l'amplificateur central 318 jusqu'au modèle d'entrée des amplificateurs secondaires 601 à 661.
E9: On effectue la simulation analogique du schéma électrique équivalent et on mesure des retards de phase à l'entrée de chaque amplificateur secondaire 601 à 661. Lors de la mesure des retards de phases, on détermine quel retard de phase est le plus important.
E10: On ajuste le retard d'entrée de chaque amplificateur secondaire 601 à 661 pour correspondre au retard de phase le plus important. L'ajustement se fait en rajoutant un retard en entrée de chaque amplificateur secondaire 601 à 661, le retard ajouté étant égal à la différence de retard entre le retard le plus important et le retard mesuré pour l'amplificateur concerné.

Bien évidement, pour ne pas avoir à refaire le placement des éléments constitutifs, il convient de réserver lors du placement des amplificateurs secondaires une surface suffisante qui correspond à la surface nécessaire pour obtenir un retard maximal.

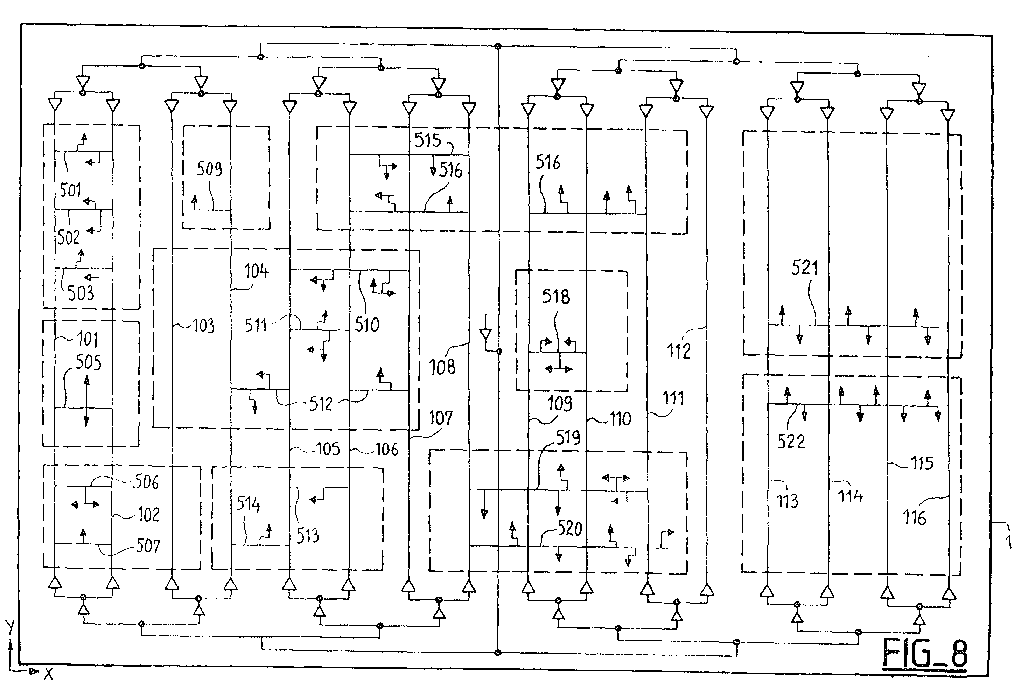

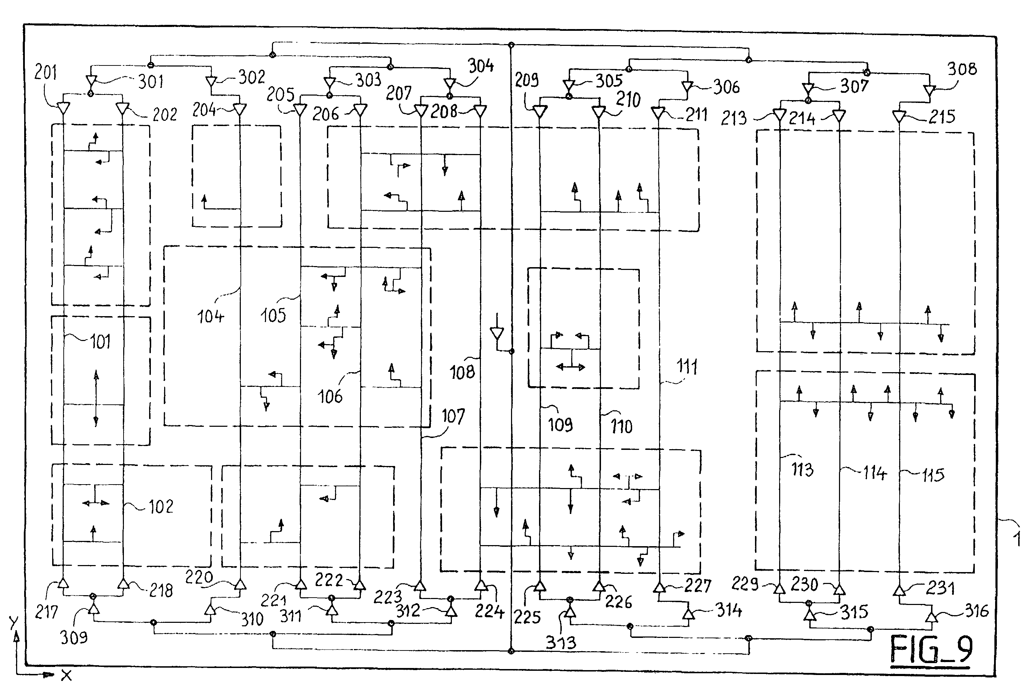

Les figures 8 et 9 représentent des perfectionnements du circuit d'horloge de la figure 7.

Sur la figure 7, on peut remarquer que certaines secondes lignes 504, 508, 515 et 517 ne sont pas utilisées. De même, les autres secondes lignes (par exemple 510) comportent des parties, situées entre deux premières lignes successives (par exemple 103 et 104), qui ne sont pas utilisées. Ces secondes lignes partiellement ou totalement inutilisées constituent des capacités parasites qui augmentent la consommation du circuit intégré.

Sur la figure 8, toutes les portions des deuxièmes lignes 501 à 522 qui sont situées entre deux premières lignes successives sont supprimées s'il n'y a pas d'amplificateur secondaire connecté sur lesdites portions. Cela revient à supprimer les secondes lignes inutilisées ainsi que les morceaux de secondes lignes inutiles qui créent des capacités parasites superflues. Bien évidemment, cette suppression doit être réalisée avant d'effectuer l'extraction de schéma équivalent de l'étape E10.

La figure 9 représente le circuit intégré 1 encore plus optimisé vis à vis de la consommation d'énergie. Sur cette figure 9, les premières lignes 103, 112 et 116 non reliées à au moins un amplificateur secondaire ont été supprimées. Bien évidemment, cette suppression est réalisée avant d'extraire le schéma électrique équivalent de l'étape E10. La suppression des premières lignes peut aussi se faire indépendamment de la suppression des secondes lignes.

Toujours dans le même esprit de réduction de la consommation, les premiers amplificateurs 203, 212, 216, 219, 228 et 232 connectés aux premières lignes 103, 112 et 116 qui ont été supprimées sont également supprimés. La suppression des premiers amplificateurs 203, 212, 216, 219, 228 et 232 provoque un déséquilibre sur les premier amplificateurs 204, 211, 215, 220, 227 et 231 relié aux mêmes deuxièmes amplificateurs 302, 306, 308, 310, 314 et 316. Le déséquilibre ainsi créé peut être récupéré par le retard d'entrée des amplificateurs secondaires. Toutefois, si l'on désire éviter d'avoir une variation de retard trop importante à récupérer, il n'est pas nécessaire de supprimer les premiers amplificateurs.

Il est préférable de ne pas supprimer de deuxième amplificateur car cela déséquilibrerait complètement la structure arborescente de manière importante et moins facilement récupérable.

Afin de diminuer les corrections de retard en entrée des amplificateurs secondaires, il est possible de faire une compensation prévisionnelle sur les premiers amplificateurs. Pour cela, chacun des premiers amplificateurs est dimensionné, avant d'extraire le schéma équivalent, en fonction de la surface des premières et deuxièmes lignes connectées à la sortie dudit premier amplificateur secondaire. Cette compensation peut se faire à partir du moment où les deuxième lignes sont positionnées. La surface totale des premières et deuxièmes lignes définit une trame de résistances et de condensateurs parasites dont le modèle équivalent vu par la sortie de chaque premier amplificateur est différent. Il suffit d'extraire pour chaque premier amplificateur la charge équivalente et de dimensionner l'étage de sortie de chaque premier amplificateur en fonction de la sa charge équivalente.

Au niveau de la compensation de retard faite au niveau de chaque amplificateur secondaire, l'extraction de schéma équivalent ne prend pas en compte les différences de tension d'alimentation sur le circuit intégré. Or, il s'avère que pour les circuits de grande dimension, la tension d'alimentation dépend également de la distance par rapport au bord du circuit intégré le plus proche. Il n'est pas possible de compenser en tension ce phénomène qui est du à la consommation électrique faite pas le circuit intégré. Les circuits à faible tension d'alimentation sont particulièrement sensibles à ce phénomène. Ainsi, pour les circuits à faible tension d'alimentation, il est préférable que les retards des amplificateurs secondaires soient ajustés également en fonction de la distance entre la position de chaque amplificateur secondaire et le bord le plus proche du circuit intégré. Le retard à ajouter peut être donné par un polynôme en x et y de degré deux dont les différents coefficients dépendent de très nombreux paramètres qui sont déterminés par le gradient de tension d'alimentation de la puce, x et y étant la position sur le circuit intégré de l'amplificateur à compenser.

Les figures 10 à 12 représentent un bloc 403 selon un mode de réalisation préféré des étapes E6 et E7 précédemment citées. Ces figures 10 à 12 représentent uniquement les éléments nécessaires à la bonne compréhension de l'invention. De même, ces figures ne sont pas à l'échelle car il aurait été impossible d'avoir un dessin lisible.

La figure 6 représente le bloc 403 dans lequel on a préalablement placé les deuxièmes lignes 506 et 507. On place dans le bloc 403 tous les composants constitutifs du bloc 403 selon une méthode connue, notamment des structures élémentaires 701 à 729 ayant besoin du signal d'horloge. Par structure élémentaire 701 a 729, il faut comprendre des bascules synchrones ayant une unique entrée de signal d'horloge.

Après ce premier placement, on regroupe les structures élémentaires 701 à 729 par groupe 801 à 803 de proximité, chaque groupe 801 à 803 ayant un nombre de structures élémentaires 701 à 729 inférieur ou égal à un nombre maximal (par exemple 16) et étant étendu sur une surface inférieure ou égale à une surface maximale (par exemple 0,25 mm²). La surface maximale est à définir en fonction de la technologie utilisée. Par surface maximale on définit une surface élémentaire (par exemple un carré) dont les dimensions sont telles que l'on peut considérer que le temps de propagation entre deux points quelconque de la surface maximale est négligeable. Le nombre maximal de structures élémentaires est définit comme étant le nombre de structures qui peuvent être connectées à l'amplificateur secondaire sans changer les caractéristiques temporelles de transfert des amplificateurs secondaires. Préférentiellement, on utilise des amplificateurs secondaires dont les transistors de sortie sont dimensionnés en fonction du nombre d'éléments qui vont être connectés en sortie, chaque amplificateurs secondaire fonctionnant dans une gamme autorisant un nombre minimal et un nombre maximal de connexions. Le nombre maximal devient alors égal au nombre maximal le plus important de la gamme autorisant le plus de connexions.

Plusieurs possibilités de mise en oeuvre sont possibles et sont équivalentes. A titre d'exemple, on peut par exemple réaliser les étapes suivantes:
F1: comptage du nombre de structures élémentaires,
F2: division du nombre de structures élémentaires par le nombre maximal pour obtenir un nombre de groupe,
F3: on teste successivement toutes les positions d'un nombre de surface carrée de la taille maximale égal au nombre de groupe jusqu'à ce que qu'un placement permette d'englober toutes les structures élémentaires, ou jusqu'à ce que toutes les possibilités de placement ait été essayées,
F4: si toutes les possibilité de placement ont été essayées sans succès, alors on incrémente de 1 le nombre de groupes et on répète l'étape F3.

Dans une variante préférée, on effectue un équilibrage des groupes. Il suffit par exemple de remplacer l'étape F3 par l'étape F'3 suivante, et de rajouter l'étape F5 suivante après l'étape F4:
F'3: on teste successivement toutes les positions d'un nombre de surface carrée de la taille maximale égal au nombre de groupe et on mémorise tous les placements qui permettent d'englober toutes les structures élémentaires jusqu'à ce que toutes les possibilités de placement ait été essayées,
F5: Pour chaque placement mémorisé, on calcule l'écart type par rapport à la moyenne du nombre de structures élémentaires par groupe, puis on choisit le placement de groupe qui a le plus faible écart type.

L'homme du métier pourra appliquer l'un des nombreux autres algorithmes de placement qui sont connus pour effectuer ce placement. On peut également contrôler le bon fonctionnement des amplificateurs après routage et éventuellement utiliser un amplificateur de la gamme supérieure si les trajets de routage sont très importants.

Après la réalisation des groupes 801 à 803, on place à l'intérieur de chaque groupe 801 à 803 un amplificateur secondaire 609 à 611, comme indiqué sur la figure 11. Lors du placement des amplificateurs secondaires 609 à 611, on ne tient pas compte des éléments constitutifs du bloc 403 à l'exception des structures élémentaires 701 à 729. Préférentiellement, les amplificateurs secondaires 609 à 611 sont placés à un endroit proche du barycentre des structures élémentaires de leurs groupes 701 à 729, afin de réduire les retards au maximum.

Après avoir effectué le placement des amplificateurs secondaires 609 à 611, on effectue un nouveau placement d'une partie des éléments du bloc 403 en n'autorisant qu'un faible déplacement (par exemple quelques dizaines de µm pour une technologie CMOS 0,35 µm) pour les amplificateurs secondaires 609 à 611 et pour les structures élémentaires 701 à 729.

L'étape suivante représentée sur la figure 12 est le routage des éléments constitutifs du bloc 403. Seul les liaisons transportant le signal d'horloge ont été représentées pour simplifier la figure 12. Le routage s'effectue de manière globale dans le bloc 403, c'est à dire en tenant compte de toutes les connexions à réaliser. Quelles que soient les connexions établies à l'intérieur de chaque groupe 801 à 803, celles-ci sont, dans la plupart des cas, relativement courtes et d'influence mineure sur les différences de phases à l'entrée de chaque structure élémentaire car elles se trouvent à l'intérieur de surfaces dont la taille a été choisie pour que les temps de propagation sur les fils de connexion soient négligeables.

Sur la figure 13 est représenté un amplificateur d'horloge 900 connu de l'homme du métier. L'amplificateur d'horloge 900 est ici constitué de premier et deuxième inverseurs 901 et 902 montés en série. Le premier inverseur 901 a sa sortie connectée à l'entrée du deuxième inverseur 902. Classiquement, le premier inverseur 901 est de taille réduite, les transistors le constituant étant d'une taille proche de la taille minimale autorisée par la technologie. Le deuxième inverseur 902 est de taille plus importante, les transistors le constituant étant dimensionnés en fonction de la charge à piloter en sortie. Il existe de nombreuses variantes d'amplificateurs d'horloge utilisant un nombre pair ou impair d'inverseurs suivant que l'amplificateur soit non-inverseur ou inverseur. Le principe étant d'avoir un inverseur d'entrée de taille réduite et un inverseur de sortie dont la taille est appropriée à la charge. Le nombre d'inverseurs utilisés dépend des différences de tailles possibles pour l'inverseur de sortie afin d'amortir la variation sur plusieurs inverseurs et d'avoir des temps de propagation similaires entre deux amplificateurs d'horloge.

Dans l'invention, les premiers et deuxièmes amplificateurs 201 à 216 et 301 à 308 sont du même type que l'amplificateur d'horloge 900 de la figure 13.

Par contre, les amplificateurs secondaires 601 à 661 utilisés dans l'invention sont d'un type particulier d'amplificateur de signal d'horloge et sont représentés sur la figure 14. L'amplificateur secondaire 601 comporte un étage d'entrée 1001 et un étage de sortie 1002, montés en série.

L'étage d'entrée comporte un inverseur d'attaque 1003, un inverseur tampon 1004 et des premier et deuxième condensateurs 1005 et 1006 d'ajustement connectés à la sortie de l'inverseur d'attaque. L'inverseur d'attaque 1003 reçoit sur son entrée le signal d'horloge. L'inverseur tampon 1004 a son entrée connectée à la sortie de l'inverseur d'attaque 1003. Le premier condensateur 1005 a une première borne connectée à la sortie de l'inverseur d'attaque 1003 et une deuxième borne recevant la tension d'alimentation Vcc. Le deuxième condensateur 1006 a une première borne connectée à la sortie de l'inverseur d'attaque 1003 et une deuxième borne connectée à la masse.

Un tel étage d'entrée 1001 permet d'avoir un retard variable en fonction de la taille des premier et deuxième condensateurs 1005 et 1006. Pour cela il convient de réaliser l'amplificateur d'attaque 1003 et l'amplificateur tampon 1004 avec des transistors d'une taille proche de la taille minimale autorisée par la technologie utilisée. Comme le sait l'homme du métier, le temps de propagation entre l'inverseur d'attaque 1003 et l'inverseur tampon 1004 est proportionnel à la taille de l'inverseur d'attaque et à la charge capacitive connectée à la sortie de ce même inverseur d'attaque 1003. A taille constante des inverseurs, si on augmente la capacité sur la sortie de l'inverseur d'attaque 1003, alors on augmente proportionnellement le temps de propagation entre l'inverseur d'attaque 1003 et l'inverseur tampon 1004.

On peut remarquer qu'un seul condensateur suffirait pour produire un retard supplémentaire. Néanmoins, il convient d'équilibrer la charge capacitive entre Vcc et la masse afin avoir un pont capacitif entre Vcc et la masse qui corresponde à la tension de seuil de l'inverseur tampon 1004.

L'étage de sortie 1002 comporte deux inverseurs de sortie 1007 et 1008 montés en série. L'utilisation de deux inverseurs au lieu d'un permet d'avoir une plus large gamme de taille d'amplificateur secondaire 601. Si on désire, par exemple, avoir entre 1 et 16 structures élémentaires alimentés par l'amplificateur secondaire 601 en ayant une différence de temps de propagation négligeable quelque soit le nombre de structures, il convient alors d'avoir un inverseur de sortie 1008 dont la taille varie environ de 1 à 8. Pour ne pas avoir une variation de charge capacitive allant de 1 à 8 sur la sortie de l'inverseur tampon 1004 qui se traduirait par une variation importante, il convient alors d'avoir un inverseur intermédiaire 1007 dont la taille des transistors varie dans un rapport de 1 à 2 afin d'avoir une répercussion temporelle moindre. Si l'on désire encore diminuer la répercussion temporelle ou avoir une gamme plus importante, on peut rajouter d'autres inverseurs dans l'étage de sortie.

Dans une variante, l'un des inverseurs 1003, 1004, 1007 ou 1008 est remplacé par une porte logique, par exemple de type ET-NON ou OU-NON, l'une des entrées de la porte logique se substituant à l'entrée de l'inverseur qui est remplacé. L'autre ou les autres entrées de la porte logique servent à valider le signal d'horloge (cela permet d'arrêter partiellement l'horloge sur une partie du circuit afin de diminuer la consommation).

De nombreuses variantes de l'invention sont possibles comme cela à été indiqué dans la présente demande. Notamment, les informations numériques relatives à l'invention sont données de manière purement indicative et peuvent être remplacées par d'autre valeurs. Il convient d'adapter les valeurs numériques au circuit intégré dans lequel l'invention est mise en oeuvre. Les valeurs numériques sont également à adapter en fonction des tolérances temporelles que se fixe l'homme du métier lors de la réalisation du circuit intégré.

De même, l'invention a été présentée comme ayant un grand intérêt pour des circuits intégrés de grande dimension et fonctionnant à des fréquences élevées. Il va de soi que l'invention peut également être appliquée à des circuits de plus petite dimension ou fonctionnant à des fréquences plus faibles qui demandent une grande précision pour la synchronisation de signal d'horloge.

## Revendications

1. Procédé de placement-routage d'un circuit d'horloge sur un circuit intégré (1) dont la surface s'étend selon des première et deuxième directions (X et Y) distinctes l'une de l'autre, **caractérisé en ce qu'**il comporte les étapes suivantes:
- placement de premières lignes (101 à 116) conductrices parallèles à la première direction (Y) régulièrement espacées selon la deuxième direction (X), les premières lignes (101 à 116) conductrices étant connectées sur au moins une extrémité à des sorties de premiers amplificateurs (201 à 232), un dispositif en structure d'arbre équilibrée (301 à 317) fournissant à chacun des premiers amplificateurs un signal d'horloge provenant d'une unique source (318);
- placement de blocs (401 à 411) fonctionnels formant le circuit intégré (1)
- placement de secondes lignes (501 à 522) parallèles à la deuxième direction (X), chaque seconde ligne (501 à 522) étant associée à un seul bloc (401 à 411);
- placement dans chaque bloc (401 à 411) d'amplificateurs secondaires (601 à 661) en fonction des besoins de chaque bloc (401 à 411), chaque amplificateur secondaire (601 à 661) disposant d'un dispositif de retard ajustable en entrée puis routage de chaque amplificateur secondaire (601 à 661) à la seconde ligne (501 à 522) la plus proche;
- extraction d'un schéma électrique équivalent correspondant au parcours du signal d'horloge entre l'entrée (318) du dispositif en structure d'arbre (301 à 317) et l'entrée de chaque amplificateur secondaire (601 à 661);
- simulation analogique du schéma électrique équivalent et mesure des retards de phase à l'entrée de chaque amplificateur secondaire (601 à 661);
- ajustement du retard d'entrée de chaque amplificateur secondaire (601 à 661) pour correspondre au retard de phase le plus important.

2. Procédé selon la revendication 1, **caractérisé en ce qu'**il comporte les étapes suivantes:
- placement dans chaque bloc (403) des structures élémentaires (701 à 729) ayant besoin du signal d'horloge;
- regroupement des structures élémentaires (701 à 729) par groupe (801 à 803) de proximité, chaque groupe (801 à 803) ayant un nombre de structures élémentaires (701 à 729) inférieur ou égal à un nombre maximal et étant étendu sur une surface inférieure ou égale à une surface maximale;
- placement à l'intérieur de chaque groupe (801 à 803) d'un amplificateur secondaire (609 à 611).

3. Procédé selon la revendication 2, **caractérisé en ce que**, après le regroupement des structures élémentaires (701 à 729), on effectue un équilibrage des groupes (801 à 803).

4. Procédé selon l'une des revendications 2 ou 3, **caractérisé en ce que** les transistors de sortie de chaque amplificateur secondaire (609 à 611) sont dimensionnés en fonction du nombre de structures élémentaires (701 à 729) présentes dans le groupe (801 à 803) auxquelles l'amplificateur secondaire (609 à 611) est associé.

5. Procédé selon l'une des revendications 2 à 4, **caractérisé en ce que** les amplificateurs secondaires (609 à 611) sont placés à un endroit proche du barycentre des structures élémentaires (701 à 729) de leurs groupes (801 à 803).

6. Procédé selon l'une des revendications 1 à 5, **caractérisé en ce que**, avant d'extraire le schéma électrique équivalent, les premières lignes (103, 112 et 116), non reliées à au moins un amplificateur secondaire (601 à 661), sont supprimées.

7. Procédé selon la revendication 6, **caractérisé en ce que** les premiers amplificateurs (203, 212, 216, 219, 228 et 232) connectés aux premières lignes (103, 112 et 116) qui sont supprimées sont également supprimés.

8. Procédé selon l'une des revendications 1 à 7, **caractérisé en ce que** les portions des deuxièmes lignes (501 à 522) qui sont situés entre deux premières lignes (101 à 116) sont supprimés si il n'y a pas d'amplificateur secondaire (601 à 661) connecté sur lesdites portions.

9. Procédé selon l'une des revendications 1 à 8, **caractérisé en ce que** les premières lignes (101 à 116) sont placées sur un niveau de métal qui correspond au niveau de métal utilisé pour l'alimentation du circuit intégré (1).

10. Procédé selon l'une des revendications 1 à 9, **caractérisé en ce que** les retards des amplificateurs secondaires (601 à 661) sont ajustés également en fonction de la distance entre la position de chaque amplificateur secondaire (601 à 661) et le bord le plus proche du circuit intégré (1).

11. Procédé selon l'une des revendications 1 à 10, **caractérisé en ce que** les premières lignes (101 à 116) et les secondes lignes (501 à 522) sont respectivement placées sur un premier et un deuxième niveaux de métal, les premier et deuxième niveaux de métal étant distincts l'un de l'autre.

12. Procédé selon l'une des revendications 1 à 11, **caractérisé en ce que** chacun des premiers amplificateurs (201 à 232) est dimensionné en fonction de la surface des premières et deuxièmes lignes (101 à 116 et 501 à 522) connectés à la sortie dudit premier amplificateur secondaire (201 à 232).

13. Circuit intégré (1) ayant un circuit d'horloge, susceptible d'être obtenu par mise en oeuvre du procédé selon l'une des revendications 1 à 12 et **caractérisé en ce qu'**il comporte au moins un amplificateur secondaire (601 à 661) comportant un étage d'entrée (1001) et un étage de sortie (1002), l'étage d'entrée comportant un inverseur d'attaque (1003) qui reçoit sur son entrée le signal d'horloge, et au moins un condensateur (1005, 1006) d'ajustement connecté à la sortie de l'inverseur d'attaque (1003) pour produire un retard en entrée dudit amplificateur (601).

14. Circuit intégré selon la revendication 13, **caractérisé en ce que** le circuit d'horloge comporte une structure arborescente (301 à 316) au moins partiellement équilibrée qui fournit un signal d'horloge à une série de premiers amplificateurs (201 à 232), et une structure de connexions non équilibrée (101 à 116 et 501 à 522) qui relie les sorties des premiers amplificateurs (201 à 232) à l'au moins un amplificateur secondaire (601 à 661).

## Patentansprüche

1. Verfahren zur Leitungsführung bei einem Taktgeberschaltkreis in einem integrierten Schaltkreis (1), dessen Oberfläche sich in einer ersten und unterschiedlichen zweiten Richtung (x und y) erstreckt, **dadurch gekennzeichnet, dass** es die folgenden Schritte umfasst:
Anordnen von ersten Leitungen (101-116) parallel zu der ersten Richtung (y), die gleichmässig beabstandet sind in der zweiten Richtung (x), wobei die ersten Leitungen (101-116) mit wenigstens einem Ende mit Ausgängen von ersten Verstärkern (201-232) verbunden sind, eine Vorrichtung mit der Struktur eines ausgeglichenen Baumes (301-317) an jeden der ersten Verstärker ein Taktsignal ausgibt, das von einer einheitlichen Quelle (318) stammt,
anordnen von Funktionsblöcken (401-411), die den integrierten Schaltkreis (1),
anordnen von zweiten Leitungen (501-522) parallel zu der zweiten Richtung (x), wobei jede zweite Leitung (501-522) zu einem einzigen Block (401-411) gehört,
anordnen in jedem Block (401-411) von Sekundärverstärkern (601-661) in Abhängigkeit von den Anforderungen bei jedem Block (401-411), wobei jeder Sekundärverstärker (601-661) aus einer einstellbaren Verzögerungsvorrichtung am Eingang und dann einer Führung von jedem Sekundärverstärker (601-661) zu der zweiten Leitung (501-522) auf die kürzeste Weise besteht,
Extraktion eines elektrischen Äquivalenzplans, der dem Pfad des Taktsignals zwischen dem Eingang (318) der Vorrichtung in Baumform (301-317) und dem Eingang jedes Sekundärverstärkers (601-661) entspricht,
analoge Simulation des elektrischen Äquivalenzplans und messen der Verzögerungen in der Phase am Eingang jedes Sekundärverstärkers (601-661),
anpassen der Verzögerung am Eingang jedes Sekundärverstärkers (601-661), um eine Übereinstimmung mit der grössten Phasenverzögerung zu bewirken.

2. Verfahren nach Anspruch 1, **dadurch gekennzeichnet, dass** es die folgenden Schritte umfasst:
Anordnen in jedem Block (403) von Elementarstrukturen (701-729), die mit dem Taktsignal versorgt werden müssen,
Neugruppierung der Elementarstrukturen (701-729) in Gruppen (801-803) gleicher Nähe, wobei jede Gruppe (801-803) eine Anzahl von Elementarstrukturen aufweist, die kleiner oder gleich einer maximalen Anzahl ist, und sich über eine Oberfläche erstreckt, die kleiner oder gleich einer maximalen Oberfläche ist,
anordnen eines Sekundärverstärkers (609-611) in jeder Gruppe (801-803).

3. Verfahren nach Anspruch 2, **dadurch gekennzeichnet, dass** nach der Neugruppierung der Elementarstrukturen (701-729) ein Ausgleich der Gruppen (801-803) erfolgt.

4. Verfahren nach einem der Ansprüche 2 oder 3, **dadurch gekennzeichnet, dass** die Ausgangstransestoren jedes Sekundärverstärkers (609-611) in Abhängigkeit von der Anzahl der Elementarstrukturen (701-729) in der Gruppe (801-803) dimensioniert sind, zu denen der Sekundärverstärker (609-611) gehört.

5. Verfahren nach einem der Ansprüche 2 bis 4, **dadurch gekennzeichnet, dass** die Sekundärverstärker (609-611) an einem Ort angeordnet sind, der in der Nähe des Schwerpunkts der Elementarstrukturen (701-729) ihrer Gruppen (801-803) liegt.

6. Verfahren nach einem der Ansprüche 1 bis 5, **dadurch gekennzeichnet, dass** vor dem Extrahieren des elektrischen Äquivalenzplans die ersten Leitungen (103, 112 und 116), die nicht mit wenigstens einem Sekundärverstärker (601-661) verbunden sind, unterdrückt werden.

7. Verfahren nach Anspruch 6, **dadurch gekennzeichnet, dass** die ersten Verstärker (203, 212, 216, 219, 228 und 232), die mit den ersten Leitungen (103, 112 und 116) verbunden sind, die unterdrückt werden, ebenfalls unterdrückt werden.

8. Verfahren nach einem der Ansprüche 1 bis 7, **dadurch gekennzeichnet, dass** die Abschnitte der zweiten Leitungen (501-522), die zwischen zwei ersten Leitungen (101-116) liegen, unterdrückt werden, wenn es keinen Sekundärverstärker (601-661) gibt, der mit den Abschnitten verbunden ist.

9. Verfahren nach einem der Ansprüche 1 bis 8, **dadurch gekennzeichnet, dass** die ersten Leitungen (101-116) auf einer Metallebene angeordnet sind, die der Metallebene entspricht, die für die Versorgung des integrierten Schaltkreises (1) verwendet wird.

10. Verfahren nach einem der Ansprüche 1 bis 9, **dadurch gekennzeichnet, dass** die Verzögerung der Sekundärverstärker (601-661) ebenfalls in Abhängigkeit von dem Abstand zwischen der Position jedes Sekundärverstärkers (601-661) und den nächsten Rand des integrierten Schaltkreises (1) angepasst werden.

11. Verfahren nach einem der Ansprüche 1 bis 10, **dadurch gekennzeichnet, dass** die ersten Leitungen (101-116) und die zweiten Leitungen (501-522) jeweils auf einer ersten und einer zweiten Metallebene angeordnet sind, wobei die erste und zweite Metallebene sich voneinander unterscheiden.

12. Verfahren nach einem der Ansprüche 1 bis 11, **dadurch gekennzeichnet, dass** jeder der ersten Verstärker (201-232) in Abhängigkeit von der Oberfläche der ersten und zweiten Leitungen (101-116 und 501-522), die mit dem Ausgang des ersten Sekundärverstärkers (201-232) verbunden sind, dimensioniert wird.

13. Integrierter Schaltkreis (1) mit einem Taktgeber, der durch Ausführung des Verfahrens nach einem der Ansprüche 1 bis 12 erzeugt worden sein kann, **dadurch gekennzeichnet, dass** er wenigstens einen Sekundärverstärker (601-661) umfasst, mit einer Eingangsstufe (1001) und einer Ausgangsstufe (1002), wobei die Eingangsstufe einen Eingangsentwerter (1003) umfasst, der an seinem Eingang das Taktsignal einliest, und wenigstens einen Anpassungskondensator (1005, 1006), der mit dem Ausgang des Eingangsentwerters (1003) verbunden ist, um eine Eingangsverzögerung des Verstärkers (601) zu bewirken.

14. Integrierter Schaltkreis nach Anspruch 13, **dadurch gekennzeichnet, dass** der Taktgeber eine baumartige Struktur (301-316) aufweist, die wenigstens teilweise ausgeglichen ist und die ein Taktsignal an eine Folge von ersten Verstärkern (201-232) ausgibt, sowie eine Struktur von nicht ausgeglichenen Verbindungen (101-116 und 501-522), die die Ausgänge der ersten Verstärker (201-232) mit dem wenigstens einen Sekundärverstärker (601-661) verbindet.

## Claims

1. Method of laying out/routeing a clock circuit, on an integrated circuit (1) whose surface extends in first and second directions (X and Y), which are different from one another, **characterised in that** it comprises the following steps:
- laying out first conductive lines (101 to 116) which are parallel to the first direction (Y) and regularly spaced in the second direction (X), the first conductive lines (101 to 116) being connected at at least one end to outputs of first amplifiers (201 to 232), a device laid out in a balanced tree structure (301 to 317) supplying a clock signal coming from a single source (318) to each of the first amplifiers,
- laying out functional blocks (401 to 411) forming the integrated circuit (1),
- laying out second lines (501 to 522) parallel to the second direction (X), each second line (501 to 522) being associated with a single block (401 to 411),
- laying out secondary amplifiers (601 to 661) in each block (401 to 411) as a function of the requirements of each block (401 to 411), each secondary amplifier (601 to 661) having an adjustable delay device at its input, and then routeing each secondary amplifier (601 to 611) to the closest second line (501 to 522),
- extracting an equivalent electrical circuit representing the path of the clock signal between the input (318) of the device laid out in a tree structure (301 to 317) and the input of each secondary amplifier (601 to 661),
- making an analogue simulation of the equivalent electrical circuit and measuring the phase lags at the input of each secondary amplifier (601 to 661),
- adjusting the input lag at each secondary amplifier (601 to 662) to correspond to the longest phase lag.

2. Method according to claim 1, **characterised in that** it comprises the following steps:
- laying out in each block (403) unit structures (701 to 729) which need the clock signal,
- grouping the unit structures (701 to 729) into proximity groups (801 to 803), each group (801 to 803) having a number of unit structures (701 to 729) equal to or less than a maximum number and extending over an area equal to or less than a maximum area,
- laying out a secondary amplifier (609 to 611) within each group (801 to 803).

3. Method according to claim 2, **characterised in that**, after the grouping of the unit structures (701 to 729), the groups (801 to 803) are balanced.

4. Method according to either of claims 2 and 3, **characterised in that** the output transistors of each secondary amplifier (609 to 611) are sized as a function of the number of unit structures (701 to 729) present in the group (801 to 803) with which structures the secondary amplifier (609 to 611) is associated.

5. Method according to any of claims 2 to 4, **characterised in that** the secondary amplifiers (609 to 611) are laid out at a point close to the barycentre of the unit structures (701 to 729) in their groups (801 to 803).

6. Method according to any of claims 1 to 5, **characterised in that**, before the equivalent electrical circuit is extracted, the first lines (103, 112 and 116) which are not connected to at least one secondary amplifier (601 to 661) are deleted.

7. Method according to claim 6, **characterised in that** the first amplifiers (203, 212, 216, 219, 228 and 232) which are connected to the first lines (103, 112 and 116) are deleted likewise.

8. Method according to any of claims 1 to 7, **characterised in that** the portions of the second lines (501 to 522) which are situated between two first lines (101 to 116) are deleted if there is no secondary amplifier (601 to 661) connected to said portions.

9. Method according to any of claims 1 to 8, **characterised in that** the first lines (101 to 116) are laid out on a level of metal which corresponds to the level of metal used for the supply of the integrated circuit (1).

10. Method according to any of claims 1 to 9, **characterised in that** the lags at the secondary amplifiers (601 to 661) are also adjusted as a function of the distance between the position of each secondary amplifier (601 to 661) and the closest edge of the printed circuit (1).

11. Method according to any of claims 1 to 10, **characterised in that** the first lines (101 to 116) and the second lines (501 to 522) are placed on first and second levels of metal respectively, the first and second levels of metal being different from one another.

12. Method according to any of claims 1 to 11, **characterised in that** each of the first amplifiers (201 to 232) is sized as a function of the area of the first and second lines (101 to 116 and 501 to 522) which are connected to the output of said first secondary amplifier (201 to 232).

13. Integrated circuit (1) having a clock circuit, which is capable of being obtained by employing the method according to any of claims 1 to 12 and **characterised in that** it comprises at least one secondary amplifier (601 to 661) having an input stage (1001) and an output stage (1002), the input stage comprising an input inverter (1003) which receives the clock signal at its input, and at least one adjusting capacitor (1005, 1006) connected to the output of the input inverter (1003) to produce a lag at the input of said amplifier (601).

14. Integrated circuit according to claim 13, **characterised in that** the clock circuit comprises an at least partly balanced tree structure (301 to 316) which supplies a clock signal to a series of first amplifiers (201 to 232) and an unbalanced structure of connections (101 to 116 and 501 to 522) which connects the outputs of the first amplifiers (201 to 232) to at least one secondary amplifier (601 to 661).
